# EUROPEAN PATENT SPECIFICATION

(11) **EP 0 467 273 B1**
(45) Date of publication and mention of the grant of the patent: **18.09.1996**
(21) Application number: 91111789.3
(22) Date of filing: 15.07.1991
(51) Int. Cl.: H03K 3/037, H03K 3/356

(54) **Master-slave type flip-flop circuit**
Flip-Flop-Schaltung vom "Master-Slave"-Typ
Circuit flip-flop du type maître-esclave

(30) Priority: 18.07.1990 JP 188100/90
(43) Date of publication of application: 22.01.1992
(73) Proprietor: SONY CORPORATION, Tokyo (JP)
(72) Inventor: Takano, Chiaki, Shinagawa-ku, Tokyo (JP)
(74) Representative: TER MEER - MÜLLER - STEINMEISTER & PARTNER

(56) References cited:
- INTERNATIONAL ELECTRON DEVICES MEETING 1988 December 1988, SAN FRANCISCO CA, US pages 700 - 703; M. TSUNOTANI ET AL.: 'Advanced Self-Alignment Process Technique with Very Thick Sidewall for High Speed GaAs LSIs'
- PATENT ABSTRACTS OF JAPAN vol. 14, no. 182 (E-91)12 April 1990
- PATENT ABSTRACTS OF JAPAN vol. 9, no. 123 (E-317)28 May 1985
- PATENT ABSTRACTS OF JAPAN vol. 5, no. 11 (E-42)(683) 23 January 1981
- MALCOLM E. GOODGE 'Semiconductor Device Technology' 1983 , HOWARD W. SAMS & CO., INC. , INDIANAPOLIS US pages 240-244;
- PATENTS ABSTRACTS OF JAPAN, vol. 11, no. 104 (E-494) 02 April 1987 & JP-A-61 252 707
- PATENTS ABSTRACTS OF JAPAN, vol. 11, no. 122 (E-500) 16 April 1987 & JP-A-61 269 412

## Description

### FIELD OF THE INVENTION

The present invention relates to a master-slave type flip-flop circuit, in accordance with the precharacterizing part of claim 1. Such a master-slave type flip-flop circuit is known from Patent Abstracts of Japan, volume 14, No. 182 (E-91), 12 April 1990 and JP-A-20034018.

### DESCRIPTION OF THE PRIOR ART

A master-slave type flip-flop circuit is conventionally known which is constituted, for example, from a compound semiconduction (GaAs) IC (integrated circuit) wherein a GaAs MES FET (GaAs metal semiconductor field effect transistor) is employed as a logic gate element as disclosed, for example, in Japanese Patent Laid-Open Application No. 63-280509.

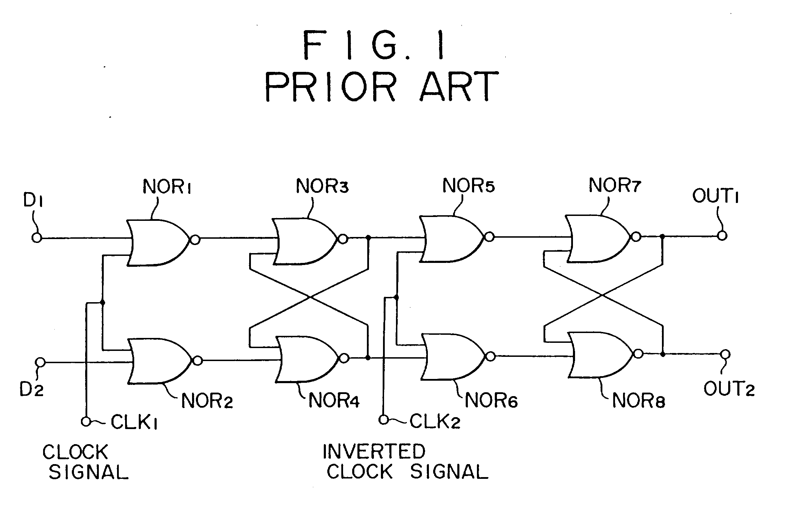

Referring to Fig. 1, there is shown in circuit diagram an exemplary one of such conventional master-slave type flip-flop circuits. The flip-flop circuit shown includes first to eighth NOR circuits NOR₁ to NOR₈. The third and fourth NOR circuits NOR₃ and NOR₄ and the seventh and eighth NOR circuits NOR₇ and NOR₈ constitute each a flip-flop circuit. The first and second NOR circuits NOR₁ and NOR₂ are connected to receive an input pulse signal and an inverted input pulse signal by way of a data input terminal D₁ and an inverted data input terminal D₂, respectively, and to receive a clock signal by way of a clock input terminal CLK₁. The fifth and sixth NOR circuits NOR₅ and NOR₆ are connected to receive outputs of the third and fourth NOR circuits NOR₃ and NOR₄, respectively, and to receive an inverted clock signal by way of an inverted clock input terminal CLK₂. Outputs of the seventh and eighth NOR circuits NOR₇ and NOR₈ are connected to an output terminal OUT₁ and an inverted output terminal OUT₂ respectively, of the master-slave type flip-flop circuit. It is to be noted that each of the NOR circuits NOR₁ to NOR₈ is constituted from a logic gate formed from, for example, a GaAs MES FET.

The master-slave type flip-flop circuit of Fig. 1 has a drawback that a high speed operation cannot be anticipated because the first NOR circuit NOR₁, third NOR circuit NOR₃, fifth NOR circuit NOR₅ and seventh NOR circuit NOR₇ (or the second NOR circuit NOR₂, fourth NOR circuit NOR₄, sixth NOR circuit NOR₆ and eighth NOR circuit NOR₈) are present on a signal transmission line and, if the gate delay time by one NOR circuit is, for example, 30 ps where each gate is formed from a GaAs MES FET, then the total delay time is 120 ps.

Document D₁ differs from the subject matter of the present invention in that the former includes transfer gates as feed back elements for feeding back the inverse output signals of the first and second data holding section, said transfer gates being controlled by the inverted clock signal and the non-inverted clock signal, respectively.

### SUMMARY OF THE INVENTION

It is an object of the present invention to provide a master-slave type flip-flop circuit which involves reduced delay time and low power consumption and therefore, achieves high operating speed and can be applied for optical communication systems.

The above object is, according to the invention, solved by the features specified in claim 1. Depending claims 2 and 3 are each specifying advantageous developments thereof.

According to an essential aspect of the present invention, a master-slave type flip-flop circuit, comprising first and second transmission gates for receiving an input pulse signal and an inverted input pulse signal at a data input terminal and an inverted data input terminal, respectively, and for receiving a clock signal at a common clock input terminal, a first data holding section (Dᵣ₁) including first and second invertors having their input terminals coupled to the outputs of said first and second transmission gates, respectively, third and fourth transmission gates for receiving outputs of said first and second invertors, respectively, of said first data holding section and for receiving an inverted clock signal at a common inverted clock input terminal (CLK₂), and a second data holding section including third and fourth invertors having their input terminals coupled to the outputs of said third and fourth transmission gates, respectively, **is characterized by** first and second resistors cross connected between input and output terminal of said first and second invertors, and third and fourth resistors cross-connected between input and output terminals of said third and fourth invertors and further first to fourth capacitors connected in parallel to said first to fourth resistors, respectively, to raise the maximum operation frequency and to eliminate deterioration caused by said first to fourth resistors, wherein each of said first to fourth transmission gates and said first to fourth invertors is formed from a GaAs field effect transistor.

With the master-slave type flip-flop circuit, the number of invertors on a signal transmission line is reduced so that a high speed operation twice that of a conventional master-slave type flip-flop circuit can be achieved.

Further, as capacities between the gates and sourced of GaAs FETs of the first to fourth transmission gates are charged and discharged by way of the first and fourth capacitors connected in parallel to the first to fourth resistors, respectively, a high maximum operating frequency can be assured.

The above and other objects, features and advantages of the present invention will become apparent from the following description and the appended claims, taken in conjunction with the accompanying drawings in which like parts or elements are denoted by like reference characters.

### BRIEF DESCRIPTION OF THE DRAWINGS

Fig. 1 is a circuit diagram showing an exemplary one of conventional master-slave type flip-flop circuits:
Fig. 2 is a circuit diagram showing a master-slave type flip-flop circuit having cross-connected resistors in the first and second data holding sections;
Fig. 3 is a circuit diagram showing details of a data holding section of the master-slave type flip-flop circuit of Fig. 2:
Fig. 4 is a timing chart illustrating operation of the master-slave type flip-flop circuit of Fig. 2:
Fig. 5 is a circuit diagram of a data identifying circuit of an optical communication system to which a master-slave type flip-flop circuit is incorporated: and
Fig. 6 is a circuit diagram showing a master-slave type flip-flop circuit according to the present invention.

### DESCRIPTION OF THE PREFERRED EMBODIMENTS

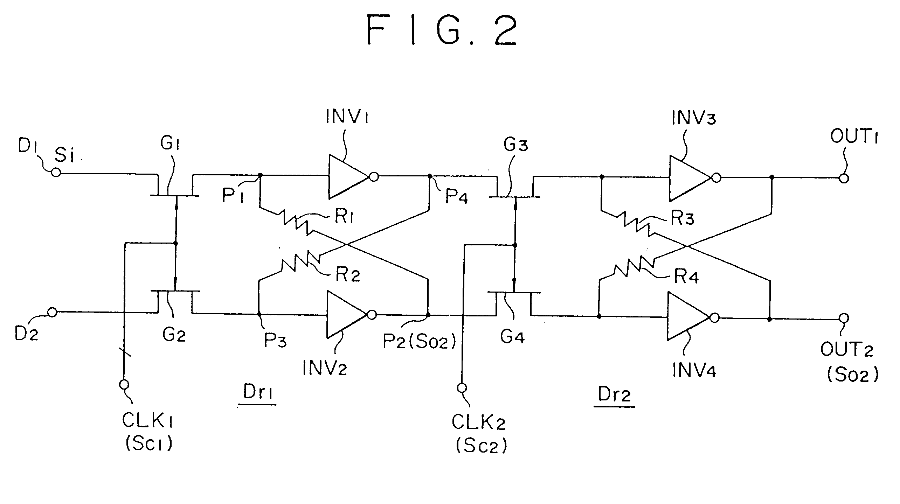

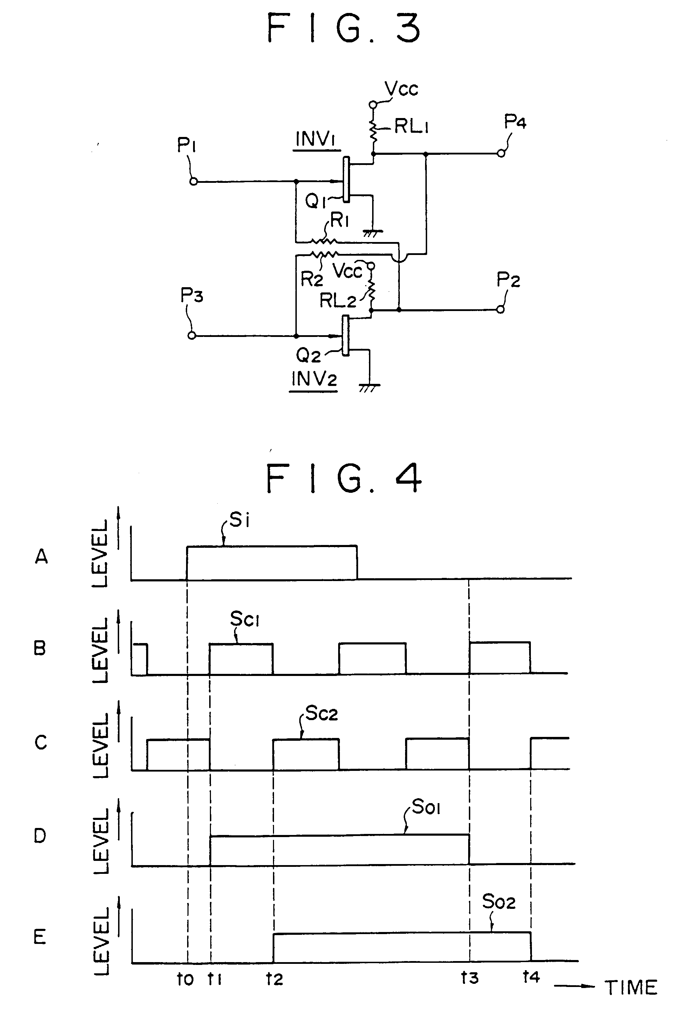

Referring first to Fig. 2, there is shown in circuit diagram a master-slave type flip-flop circuit. The master-slave type flip-flop circuit shown has a data input terminal D₁ and an inverted data input terminal D₂ and includes first to fourth transmission gates G₁ to G₄ each formed from a GaAs FET such as GaAs MES FET, a GaAs JFET (junction type field effect transistor) or a GaAs HEMT (high electron mobility transistor), and first to fourth invertors INV₁ to INV₄. A clock signal S_{c1} is supplied to the first and second gates G₁ and G₂ by way of a clock input terminal CLK₁ while an inverted clock signal S_{c2} is supplied to the third and fourth gates G₃ and G₄ by way of an inverted clock input terminal CLK₂. The master-slave type flip-flop circuit further has an output terminal OUT₁ and an inverted output terminal OUT₂. The master-slave type flip-flop circuit further includes a first resistor R₁ connected between an input terminal P₁ of the first inverter INV₁ and an output terminal P₂ of the second inverter INV₂. A second resistor R₂ is connected between an input terminal P₃ of the second invertor INV₂ and an output terminal P₄ of the first inverter INV₁. A third resistor R₃ is connected between an input terminal of the third inverter INV₃ and the inverted output terminal OUT₂ of the fourth invertor INV₄. A fourth resistor R₄ is connected between an input terminal of the fourth invertor INV₄ and the output terminal OUT₁ of the third invertor INV₃. The master-slave type flip-flop circuit further includes a first data holding section Dᵣ₁ composed of the first and second invertors INV₁ and INV₂ and the first and second resistors R₁ and R₂, and a second data holding section Dᵣ₂ composed of the third and fourth invertors INV₃ and INV₄ and the third and fourth resistors R₃ and R₄. Each of the first to fourth invertors INV₁ to INV₄ employs, as seen from Fig. 3 which shows a data holding section of a master-slave type flip-flop circuit of the present invention, a pair of GaAs FETs Q₁ and Q₂ such as, for example, GaAs MES FETs, GaAs JFETs or GaAs HEMTs as logic gate elements. It is to be noted that, while only the first data holding section Dᵣ₁ is shown in Fig. 3, also the second data holding section Dᵣ₂ has a substantially similar construction. In Fig. 3, reference characters RL₁ and RL₂ denote each a load resistor formed from a depletion type GaAs MES FET or the like, and V_{cc} a power source terminal.

Subsequently, operation of the master-slave type flip-flop circuit will be described with reference to Fig. 4.

When such an input pulse signal Sᵢ as seen from a waveform curve A shown in Fig. 4 is supplied to the data input terminal D₁ at a time t_{0̸} and simultaneously another input signal similar to but inverted in phase from the input pulse signal S₁ is supplied to the inverted data input terminal D₂, the first data holding section Dᵣ₁ is set at another time t₁ of a rising edge of a clock signal S_{c1} shown by a wave form curve B in Fig. 4 which is supplied to the first and second transmission gates G₁ and G₂ by way of the clock input terminal CLK₁. The first data holding section Dᵣ₁ is reset at a further time t₃ after then. Consequently, such an output pulse signal Sₒ₁ as shown by a wave form curve D in Fig. 4 appears at the output terminal P₂ of the second invertor INV₂. Then, the second data holding section Dᵣ₂ is set at a different time t₂ of a rising edge of an inverted clock signal S_{c2} shown by a waveform curve C in Fig. 4 which is supplied to the inverted clock input terminal CLK₂, and is then reset at another time t₄. Consequently, such an output pulse signal Sₒ₂ as shown by a waveform curve E in Fig. 4 appears at the output terminal OUT₂ of the fourth invertor INV₄. When the second transmission gate G₂ is turned on at the time t₁, an output voltage of the second gate G₂ prevails over a feedback voltage supplied thereto from the output terminal P₄ of the first invertor INV₁ by way of the second resistor R₂ thereby to invert the second invertor INV₂ from a reset state into a set state. Then, a holding current is supplied to the second invertor INV₂ by way of the second resistor R₂ in order to hold the set state of the second invertor INV₂. On the other hand, when the fourth transmission gate G₄ is turned on at the time t₂, an output voltage of the fourth gate G₄ prevails over a feedback voltage supplied thereto from the output terminal OUT₁ of the third invertor INV₃ by way of the fourth resistor R₄ thereby to invert the fourth invertor INV₄ from a reset state into a set state. Then, a holding current is supplied to the fourth invertor INV₄ by way of the fourth resistor R₄ in order to hold the set state of the fourth invertor INV₄.

In this instance, if the delay time of each of the second and fourth invertors INV₂ and INV₄ is 30 ps and the delay time of each of the second and fourth transmission gates G₂ and G₄ is 5 ps, then the operating time of the master-slave type flip-flop circuit is 70 ps, which is about one half that of such conventional master-slave type flip-flop circuit as described hereinabove.

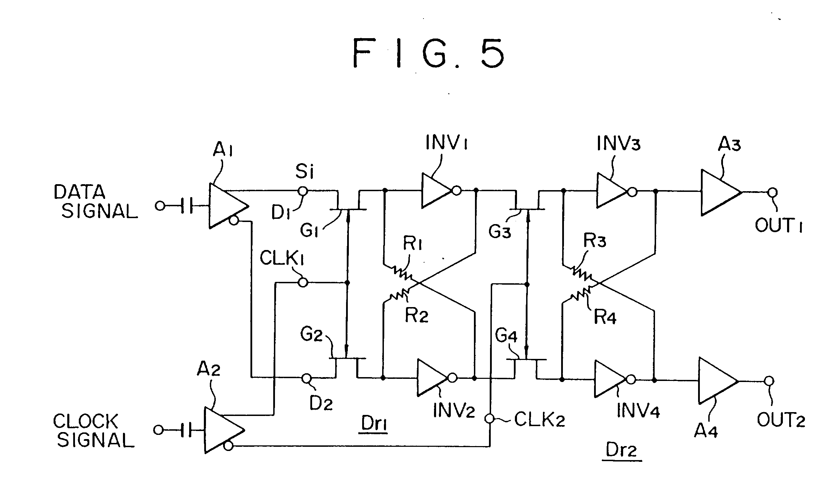

Subsequently, an exemplary application of a master-slave type flip-flop circuit will be described with reference to Fig. 5 which shows a data identifying circuit of an optical communication system.

The data identifying circuit shown in Fig. 5 includes an input amplifier A₁ which receives a data signal of an operating speed of, for example, 2.4 Gb/s and supplies an input pulse signal Sᵢ to a data input terminal D₁ and also supplies to another inverted data input terminal D₂ an inverted input pulse signal similar to but inverted in phase to the input pulse signal Sᵢ. Another input amplifier A₂ receives a clock signal having a higher frequency than the data signal and supplies a clock signal and an inverted clock signal to a clock input terminal CLK₁ and an inverted clock input terminal CLK₂, respectively. Then, whether data supplied to the input amplifier A₁ is a mark (high level) or a space (low level) is detected in synchronism with the inverted clock signal at the inverted clock input terminal CLK₂, and a result of such detection is held in the fourth invertor INV₄. The data identifying circuit further includes a pair of output amplifiers A₃ and A₄.

Also with the data identifying circuit shown in Fig. 5. similar effects to those of the master-slave type flip-flop circuit shown in Fig. 2 can be anticipated.

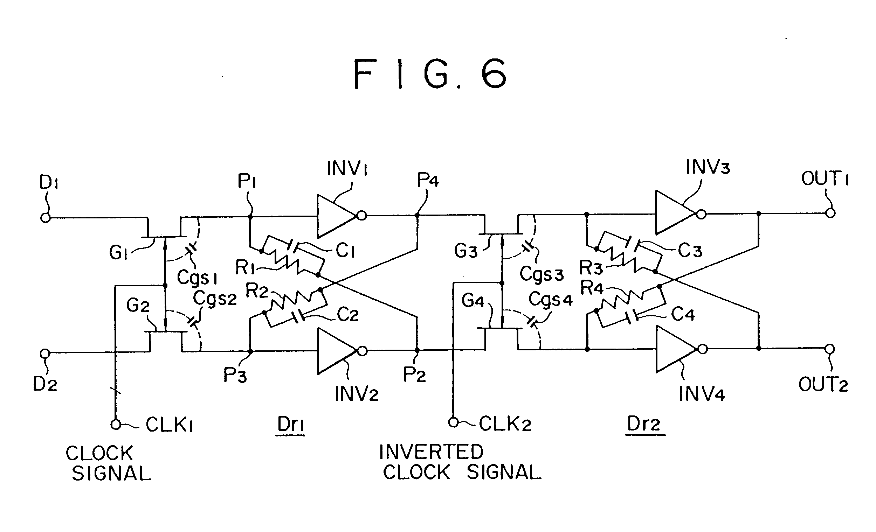

Referring now to Fig. 6, there is shown in circuit diagram a master-slave type flip-flop circuit according to the present invention. The master-slave type flip-flop circuit has a substantially similar construction to that of the master-slave type flip-flop circuit of Fig. 2 but additionally includes first to fourth capacitors C₁ to C₄ connected in parallel to the first to fourth resistors R₁ to R₄, respectively. Further, each of the first to fourth transmission gates G₁ to G₄ is formed from a GaAs FET.

In the master-slave type flip-flop circuit of Fig. 6, charging and discharging of capacities C_{gs1} to C_{gs4} between the gates and sources of GaAs FETs forming the first to fourth transmission gates G₁ to G₄ take place by way of the first to fourth capacitors C₁ to C₄, respectively. Accordingly, possible deterioration of the first to fourth resistors R₁ to R₄ and the first to fourth capacitors by time constants is eliminated and the maximum operating frequency can be raised.

As apparent from the foregoing description, with a master-slave type flip-flop circuit of the present invention, as the number of invertors on a signal transmission line is reduced, a high speed operation twice that of a conventional master-slave type flip-flop circuit can be achieved.

Further, as capacities between the gates and sources of GaAs FETs of first to fourth transmission gates are charged and discharged by way of first and fourth capacitors connected in parallel to first to fourth resistors, respectively, there is an advantage that the maximum operating frequency can be raised.

Having now fully described the invention, it will be apparent to one of ordinary skill in the art that many changes and modifications can be made thereto.

## Claims

1. A master-slave type flip-flop circuit, comprising first and second transmission gates (G₁,G₂) for receiving an input pulse signal (Sᵢ) and an inverted input pulse signal at a data input terminal (D₁) and an inverted data input terminal (D₂), respectively, and for receiving a clock signal (S_{c1}) at a common clock input terminal (CLK₁), a first data holding section (Dᵣ₁) including first and second invertors (INV₁, INV₂) having their input terminals coupled to the outputs of said first and second transmission gates, respectively, third and fourth transmission gates for receiving outputs of said first and second invertors, respectively, of said first data holding section and for receiving an inverted clock signal (S_{c2}) at a common inverted clock input terminal (CLK₂), and a second data holding section (Dᵣ₂) including third and fourth invertors (INV₃,INV₄) having their input terminals coupled to the outputs of said third and fourth transmission gates, respectively, **characterized by** first and second resistors (RT₁,RT₂) cross-connected between input and output terminal of said first and second invertors, and third and fourth resistors cross-connected between input and output terminals of said third and fourth invertors, and further first to fourth capacitors (C₁ to C₄) connected in parallel to said first to fourth resistors, respectively, to raise the maximum operation frequency and to eliminate deterioration caused by said first to fourth resistors, wherein each of said first to fourth transmission gates (G₁-G₄) and said first to fourth invertors (INV₁-INV₄) is formed from a GaAs field effect transistor.

2. A master-slave type flip-flop circuit according to claim 1, wherein each of said first to fourth transmission gates and said first to fourth invertors is formed from a GaAs metal semiconductor field effect transistor.

3. A master-slave type flip-flop circuit according to claim 1, wherein each of said first to fourth transmission gates and said first to fourth invertors is formed from a GaAs junction type field effect transistor.

## Patentansprüche

1. Master-Slave Flip-Flop Schaltung, mit:
einem ersten und einem zweiten Durchlaßtor (G₁, G₂), an denen jeweils an einem Daten Eingangsanschluß (D₁) und einem Eingangsanschluß für invertierte Daten (D₂) ein pulsförmiges Eingangssignal (Sᵢ) und ein invertiertes invertiertes pulsförmiges Eingangssignal, und an einem gemeinsamen Takt Eingangsanschluß (CLK₁) ein Taktsignal (S_{C1}) anliegt,
einem ersten Daten Speicherbereich (Dᵣ₁) mit einem ersten und einem zweiten Inverter (INV₁, INV₂), deren Eingangsanschlüsse jeweils mit den Ausgängen des ersten und des zweiten Durchlaßtores verbunden sind,
einem dritten und einem vierten Durchlaßtor, an denen jeweils die Ausgangssignale des ersten und des zweiten Inverters des ersten Daten Speicherbereichs und an deren gemeinsamen Eingangsanschluß (CLK₂) für einen invertierten Takt ein invertiertes Taktsignal (S_{C2}) anliegen, und
einem zweiten Daten Speicherbereich (Dᵣ₂) mit einem dritten und einem vierten Inverter (INV₃, INV₄), deren Eingangsanschlüsse jeweils mit den Ausgängen des dritten und des vierten Durchlaßtores verbunden sind,
**gekennzeichnet durch**
einen ersten und einen zweiten Widerstand (RT₁, RT₂), die die Eingangsanschlüsse und die Ausgangsanschlüsse des ersten und des zweiten Inverters kreuzweise verbinden, und
einen dritten und einen vierten Widerstand, die die Eingangsanschlüsse und die Ausgangsanschlüsse des dritten und des vierten Inverters kreuzweise verbinden, und weiter
einen ersten bis einen vierten Kondensator (C₁ bis C₄), die jeweils parallel mit einem der ersten bis vierten Widerstände verbunden sind, um die maximale Betriebsfrequenz anzuheben und um die durch den ersten bis vierten Widerstand verursachten Störungen zu beseitigen, wobei jedes der ersten bis vierten Durchlaßtore (G₁ bis G₄) und jeder der ersten bis vierten Inverter (INV₁ bis INV₄) aus einem GaAs Feldeffekttransistorgebildet ist.

2. Master-Slave Flip-Flop Schaltung nach Anspruch 1, **dadurch gekennzeichnet**, daß jedes der ersten bis vierten Durchlaßtore und jeder der ersten bis vierten Inverter aus einem GaAs Metall-Halbleiter Feldeffekttransistor gebildet ist.

3. Master-Slave Flip-Flop Schaltung nach Anspruch 1, **dadurch ge** **kennzeichnet,** daß jedes der ersten bis vierten Durchlaßtore und jeder der ersten bis vierten Inverter aus einem GaAs Sperrschicht Feldeffekttransistor gebildet ist.

## Revendications

1. Circuit de bascule bistable du type maître-esclave, comprenant des première et seconde portes de transmission (G₁, G₂) pour recevoir respectivement un signal impulsionnel d'entrée (Sᵢ) et un signal impulsionnel d'entrée inversée au niveau d'une borne d'entrée de données (D₁) et d'une borne d'entrée de données inversée (D₂) et pour recevoir un signal d'horloge (S_{c1}) au niveau d'une borne d'entrée d'horloge commune (CLK₁), une première section de blocage de données (Dᵣ₁) incluant des premier et second inverseurs (INV₁, INV₂) ayant leurs bornes d'entrée couplées respectivement aux sorties desdites première et seconde portes de transmission, des troisième et quatrième portes de transmission pour recevoir respectivement des sorties desdits premier et second inverseurs de ladite première section de blocage de données et pour recevoir un signal d'horloge inversée (S_{c2}) au niveau d'une borne d'entrée d'horloge inversée commune (CLK₂) et une seconde section de blocage de données (Dᵣ₂) incluant des troisième et quatrième inverseurs (INV₃, INV₄) qui ont leurs bornes d'entrée couplées respectivement aux sorties desdites troisième et quatrième portes de transmission, caractérisé par des première et seconde résistances (RT₁, RT₂) connectées en croix entre une borne d'entrée et une borne de sortie desdits premier et second inverseurs, et par des troisième et quatrième résistances connectées en croix entre des bornes d'entrée et de sortie desdits troisième et quatrième inverseurs, et en outre par des premier à quatrième condensateurs (C₁ à C₄) connectés respectivement en parallèle auxdites première à quatrième résistances, lesdites première à quatrième portes de transmission (G₁-G₄) et lesdits premier à quatrième inverseurs (INV₁-INV₄) sont chacun formés à partir d'un transistor à effet de champ en GaAs.

2. Circuit de bascule bistable du type maître-esclave selon la revendication 1, dans lequel lesdites première à quatrième portes de transmission et lesdits premier à quatrième inverseurs sont chacun formés à partir d'un transistor métal semiconducteur à effet de champ en GaAs

3. Circuit de bascule bistable du type maître-esclave selon la revendication 1, dans lequel lesdites première à quatrième portes de transmission et lesdits premier à quatrième inverseurs sont chacun formés à partir d'un transistor à effet de champ du type jonction en GaAs.
